Europäisches Patentamt

European Patent Office

Office européen des brevets

(19)

(11) Veröffentlichungsnummer: 0 164 564

A1

(12) **EUROPÄISCHE PATENTANMELDUNG**

(21) Anmeldenummer: 85105523.6

(22) Anmeldetag: 06.05.85

(51) Int. Cl.⁴: H 05 K 3/00
B 23 K 26/00

(30) Priorität: 18.05.84 DE 3418593

(43) Veröffentlichungstag der Anmeldung:
18.12.85 Patentblatt 85/51

(84) Benannte Vertragsstaaten:
AT DE FR GB IT NL SE

(71) Anmelder: Siemens Aktiengesellschaft
Berlin und München Wittelsbacherplatz 2
D-8000 München 2(DE)

(72) Erfinder: Bachmann, Friedrich, Dr. Dipl.-Phys.
Höllentalstrasse 13
D-8000 München 70(DE)

(54) **Anordnung zur Sacklocherzeugung in einem laminierten Aufbau.**

(57) Anordnung zur Erzeugung von Sacklöchern (5) für Durchkontaktierungen in einem mehrschichtigen Aufbau, und zwar insbesondere Metall-Kunststoff-Metall mit einem Excimer-Laser. Als Maske dient die strukturierte Deckschicht (1) und die untere Schicht (3) zur Beendigung des Prozesses. Die obere und untere Schicht (1, 3) sind resistent gegenüber Laserstrahlen.

Croydon Printing Company Ltd

0164564

Siemens Aktiengesellschaft

Berlin und München

Unser Zeichen

VPA 84 P 1381 E

Anordnung zur Sacklocherzeugung in einem laminierten Aufbau.

Die Erfindung betrifft eine Anordnung zur Erzeugung von Durchkontaktierungslöchern in einem mehrschichtigen Aufbau, zum Beispiel Mehrlagen-Leiterplatten, insbesondere mit einer Schichtfolge Metall-Kunststoff-Metall.

Bei mehrlagigen Leiterplatten werden die einzelnen Verdrahtungsebenen mittels sogenannter Durchkontaktierungen direkt leitend miteinander verbunden. Die Miniaturisierung der Leiterplatten wird unter anderem durch den Platzbedarf dieser Durchkontaktierungen begrenzt. Der Platzbedarf ist durch die Fläche, die für die Durchkontaktierung in der Verdrahtungsebene freigehalten werden muß, sowie durch die Länge der Durchkontaktierung festgelegt. In ihrer Länge erstreckt sich die Durchkontaktierung entweder durch die gesamte Dicke der Leiterplatte oder durch die gesamte Dicke vorgefertigter Einzelkerne innerhalb der Leiterplatte.

Es ist bekannt, die Durchkontaktierungen mechanisch zu bohren. Bei diesem Verfahren ist der Flächenbedarf der Durchkontaktierung wesentlich vom Bohrdurchmesser mitbestimmt. Beim mechanischen Bohren ist es nicht möglich, Sacklöcher zu erzeugen, welche sicher auf einer in der Leiterplatte liegenden Metallschicht enden. Der minimale Bohrdurchmesser wird vom Bohrwerkzeug begrenzt. Bei zunehmender Miniaturisierung gewinnen deshalb andere Verfahren zur Herstellung von Durchkontaktierungsöffnungen an Bedeutung.

Wed 1 Plr/18.4.1984

0164564
84 P 1381 E

Es ist ferner auch bekannt, einen fokussierten $CO_2$-Laser zur Herstellung von Durchkontaktierungslöchern im Einzelschußverfahren einzusetzen (DE-PS 27 02 844). Die untere Schicht dient bei diesem Verfahren zur Herstellung einer vielschichtigen gedruckten Schaltung zur Beendigung des Prozesses.

Der Erfindung liegt die Aufgabe zugrunde, die eingangs genannte Anordnung so zu konzipieren, daß sie auch zur Erzeugung von Sacklöchern geeignet ist und ferner der zunehmenden Miniaturisierung der Leiterplatten gerecht wird. Außerdem soll diese Anordnung nach der Erfindung auch bei ungünstigem Aspektverhältnis (Durchmesser klein gegenüber Lochtiefe) einsetzbar sein.

Diese Aufgabe wird dadurch gelöst, daß zur Erzeugung von Sacklöchern in einem Substrat, die bis zu der unteren Schicht reichen, ein Excimer-Laser Verwendung findet, daß als Maske die obere, mit dem Produkt fest verbundene strukturierte Deckschicht dient, während die untere Schicht den Prozeß beendet, und daß die obere und untere Schicht resistent gegenüber den verwendeten Laserstrahlen sind.

Weitere Einzelheiten der Erfindung ergeben sich aus den Unteransprüchen.

Der Anordnung liegt ein von R. Srinivasan (Laser Focus 19, 5, 62, 1983) entdeckter und als "ablative photodecomposition" bezeichneter photochemischer Prozeß zurunde. Die Photonenenergie reicht bei Wellenlängen unter 200 nm aus, über elektronische Anregung Bindungen in organischen Molekülen aufzubrechen. Während unterhalb einer kritischen Intensitätsschwelle die Bindungen nach dem Ende des Laserpulses wieder hergestellt werden können und somit ein sehr langsamer Abtrag stattfindet, erhalten oberhalb dieser Schwelle die Molekülfragmente soviel Überschußener-

gie in Rotations-, Vibrations- und Translationsfreiheitsgrade, daß sie das Material verlassen. In diesem Fall ist
Materialabtrag über die Absorptionstiefe zu erwarten. Da
ein erheblicher Teil der Überschußenergie in den Molekülfragmenten mitgenommen wird, findet keine nennenswerte
Erwärmung des Materials statt.

Bei der erfindungsgemäßen Anordnung zur Erzeugung von
Sacklöchern in Kunststoffschichten dient zum Beispiel ein
Kupfer/Kunststoff/Kupfer-Sandwich als Ausgangsmaterial.
An den Stellen, die später Durchkontaktierungen darstellen, wird die obere Kupferschicht nach herkömmlicher Fo-
to-Ätz-Technik abgetragen. Die verbleibende Kupferschicht
dient als Maske. An den freigeätzten Stellen, die der Laserstrahlung ausgesetzt sind, wird pro Laserpuls eine bestimmte Kunststoffschicht abgetragen. Für die zuverlässige Erzeugung einer Tiefenbohrung sind also mehrere Laserpulse notwendig. Bei der technischen Ausführung wird die
gesamte Platte - im Gegensatz zu den bekannten Einzelschußverfahren - mit dem Laserstrahl (Fläche ca. 0,5 cm x
1 cm) abgerastert, wobei mit einem Versatz von Spur zu
Spur gearbeitet wird. Bei geeigneter Wahl von Vorschubgeschwindigkeit des Substrates und Repetitionsrate des Lasers erhält jeder Punkt des Substrates eine bestimmte
Anzahl Laserpulse, wobei sich etwaige Inhomogenitäten des
Laserstrahls weitgehend ausmitteln.

Die verwendete Wellenlänge beträgt zum Beispiel 248 nm
(KrF), die Energiedichte ca. 750 mJ/cm$^2$. Der Materialabtrag stoppt an der unteren Kupferschicht, so daß sich die
gewünschten Sacklöcher mit hoher Zuverlässigkeit ergeben.

Die Anordnung nach der Erfindung ist nicht auf zylindrische Durchkontaktierungen beschränkt. Es lassen sich vielmehr damit beliebige Strukturen erzeugen. Durch Variation
des Einfallwinkels der Laserstrahlung ergibt sich sogar
die Möglichkeit zur Erzeugung schräger Lochwände.

0164564
84 P 1381 E

Die Erfindung wird anhand einer Figur erläutert. Mit 1 ist eine strukturierte Oberfläche, zum Beispiel aus Kupfer, bezeichnet. Ferner ist mit 2 eine Kunststoffschicht und mit 3 eine untere Schicht, die zum Beispiel ebenfalls aus Kupfer besteht, gekennzeichnet. Diese Schichten sind zusammenlaminiert. Die senkrecht zur Oberfläche angedeutete Strahlung 4 stammt von einem Excimer-Laser. Nach der Bestrahlung ist ein Sackloch 5 entstanden, das durch die untere Kupferschicht nach unten begrenzt wird.

4 Patentansprüche
1 Figur

0164564

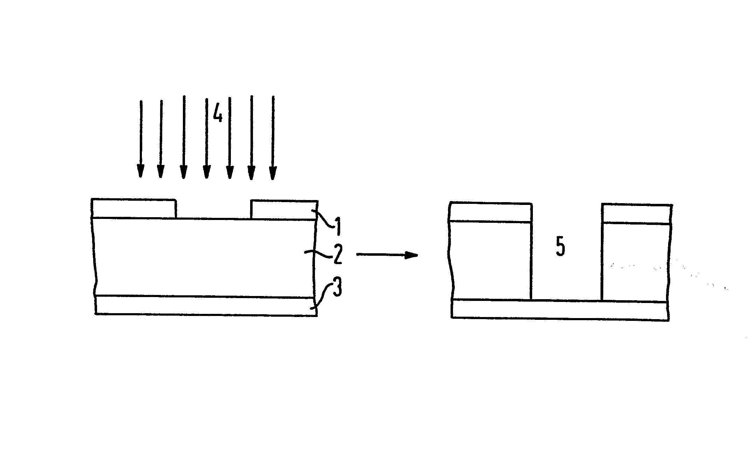

## Patentansprüche

1. Anordnung zur Erzeugung von Durchkontaktierungslöchern in einem mehrschichtigen Aufbau, zum Beispiel Mehrlagen-Leiterplatten, insbesondere mit einer Schichtfolge Metall-Kunststoff-Metall, d a d u r c h g e k e n n - z e i c h n e t , daß zur Erzeugung von Sacklöchern (5) in einem Substrat, die bis zu der unteren Schicht (3) reichen, ein Excimer-Laser Verwendung findet, daß als Maske die obere, mit dem Produkt fest verbundene strukturierte Deckschicht (1) dient, während die untere Schicht (3) den Prozeß beendet und daß die obere und untere Schicht resistent gegenüber Laserstrahlen sind.

2. Anordnung nach Anspruch 1, d a d u r c h g e - k e n n z e i c h n e t , daß bei der Verwendung von Kupfer als Deck- (1) und untere Schicht (3) der Excimer-Laser mit einer Wellenlänge von 248 nm und einer Energiedichte von ca. 750 mJ/cm$^2$ betrieben wird.

3. Anordnung nach den Ansprüchen 1 und 2, d a d u r c h g e k e n n z e i c h n e t , daß zur Erzeugung schräger Lochwände der Einfallswinkel der Laserstrahlung zur Flächennormalen geneigt ist.

4. Anordnung nach den Ansprüchen 1 bis 3, d a d u r c h g e k e n n z e i c h n e t , daß durch eine geeignete Relativbewegung des Substrates gegenüber dem Laserstrahl die gesamte Substratfläche gleichmäßig ausgeleuchtet wird.

Europäisches
Patentamt

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | FEINWERKTECHNIK & MESSTECHNIK, Band 91, Nr. 2, März 1983, Seiten 56-58, München, DE; F.J. HILLEBRAND: "Laserbohren in organischem Leiterplatten-Material" * Seite 56, Spalte 2, Absatz 3 - Seite 57, Spalte 1, Absatz 3 * | 1,2 | H 05 K 3/00 B 23 K 26/00 |
| A | US-A-4 414 059 (IBM) * Spalte 3, Zeile 56 - Spalte 4, Zeile 41; Abbildung 1 * | 1,3 | |
| A | APPLIED OPTICS, Band 23, Nr. 1; 1 Januar 1984, Seiten 18-25, New York, US; V.N. ANISIMOV u.a.: "Materials processing by high-repetition-rate pulsed excimer and carbon dioxide lasers" | | RECHERCHIERTE SACHGEBIETE (Int. Cl.4) |
| A | IBM TECHNICAL DISCLOSURE BULLETIN, Band 11, Nr. 9, Februar 1969; Seite 115, New York, US; J.F. SMITH u.a.: "Selectively removing dielectric materials" * Seite 115 * | 1,2 | H 05 K H 01 L B 23 K |
| A,D | US-A-4 030 190 (IBM) | | |

Der vorliegende Recherchenbericht wurde für alle Patentansprüche erstellt.

| Recherchenort | Abschlußdatum der Recherche | Prüfer |
|---|---|---|
| DEN HAAG | 26-08-1985 | SCHUERMANS N.F.G. |